**Europäisches Patentamt**

**European Patent Office**

**Office européen des brevets**

(19)

(11) Veröffentlichungsnummer: **0 131 679**
**B1**

(12) **EUROPÄISCHE PATENTSCHRIFT**

(45) Veröffentlichungstag der Patentschrift:
29.06.88

(51) Int. Cl.⁴: **G 01 R 11/24,** F 16 D 41/12

(21) Anmeldenummer: **84102434.2**

(22) Anmeldetag: **07.03.84**

(54) **Gesteuerte Rücklaufsperre.**

(30) Priorität: **13.06.83 CH 3230/83**

(43) Veröffentlichungstag der Anmeldung:
**23.01.85 Patentblatt 85/4**

(45) Bekanntmachung des Hinweises auf die Patenterteilung:
**29.06.88 Patentblatt 88/26**

(84) Benannte Vertragsstaaten:
**AT DE FR GB SE**

(56) Entgegenhaltungen:
**CH-A-593 432**
**DE-B-2 520 184**

(73) Patentinhaber: **LGZ LANDIS & GYR ZUG AG, CH-6301 Zug (CH)**

(72) Erfinder: **Meister, Urs, Bühlmattweg 8, CH- 6340 Baar (CH)**

(74) Vertreter: **Müller, Hans- Jürgen, Dipl.- Ing., Müller, Schupfner & Gauger Lucile- Grahn- Strasse 38 Postfach 80 13 69, D-8000 München 80 (DE)**

EP 0 131 679 B1

**Beschreibung**

Die vorliegende Erfindung bezieht sich auf eine gesteuerte, mit mehreren Sperrstellen versehene Rücklaufsperre für Impulsgeber eines Messgerätes nach dem Oberbegriff des Anspruches 1.

Eine solche Rücklaufsperre ist aus der DE-B-2 520 184 bekannt. Sie weist ein am Läufer eines Elektrizitätszählers angebrachtes Sperrad und einen in dieses eingreifenden Klinkenhebel auf, wobei der Eingriff unter der Wirkung der Schwerkraft erfolgt. Das Lager des Klinkenhebels muss dabei äusserst präzis ausgeführt sein, damit der nur ein geringes Gewicht aufweisende Klinkenhebel während der ganzen, bei Elektrizitätszählern üblicherweise sehr langen Einsatzzeit nicht ausserhalb des Eingriffs zum Stillstand kommt.

Bekannt sind ferner Rücklaufsperren mit ebenfalls auf der angetriebenen Rotorwelle festsitzendem Sperrad und einer federnden, mit diesem Sperrad zusammenwirkenden Sperrschlinge. Beim Vorwärtsdrehen der Rotorwelle gleitet das Ende der Sperrschlinge über die Zähne des Sperrades, während das Rückdrehen der Rotorwelle durch den Eingriff der Sperrschlinge mit der Sperrfläche eines der Zähne der Verzahnung verhindert wird. Das Sperrad muss einen kleinen Durchmesser aufweisen, um die Reibradien klein zu halten. Mehrere Sperrstellen auf einem kleinen Durchmesser erfordern eine sehr feine Verzahnung des Sperrades. Die auf das Sperrad in radialer Richtung wirkende Auflagekraft muss sehr klein gewählt werden, damit die zulässige Belastung des Elektrizitätszählers nicht überschritten wird. Dies führt zu einer dünnen und langen Sperrschlinge, die keine lange Lebensdauer aufweist und Probleme in der Fabrikation und Montage aufwirft.

Der vorliegenden Erfindung liegt die Aufgabe zugrunde, eine mit mehreren Sperrstellen versehene Rücklaufsperre zu schaffen, die einerseits nur eine minimale Belastung des Elektrizitätszählers darstellt, andererseits aber zwangsgesteuert ist und dabei keine Stellung möglich ist, bei der, würde das Sperrelement in dieser Stellung verharren, kein Eingriff erfolgt.

Die Lösung der gestellten Aufgabe gelingt mit Hilfe der Merkmale des Patentanspruches 1.

Ein Ausführungsbeispiel der erfindungsgemässen Rücklaufsperre wird anhand der Zeichnung näher erläutert.

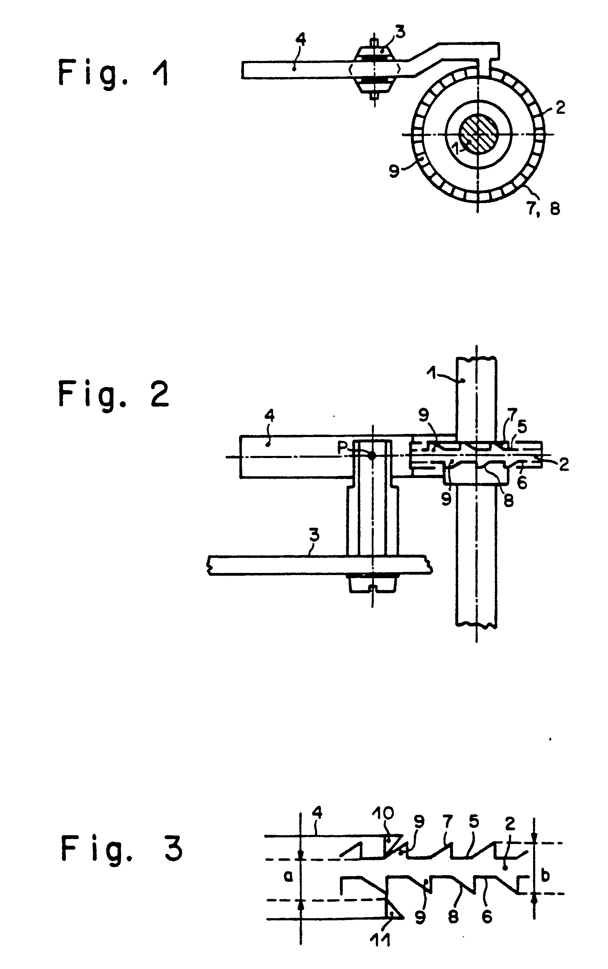

Es zeigen: Fig. 1 und 2: eine schematische Darstellung der Rücklaufsperre im Grundriss und in Seitenansicht, und

Fig. 3: eine Teilansicht des in eine Ebene abgewickelten Sperrades mit dem Sperrhebel.

Die in den Figuren abgebildete Rücklaufsperre für einen nicht gezeigten, auf einer Rotorwelle 1 eines Elektrizitätszählers angeordneten Impulsgeber besteht aus einem vorzugsweise aus Kunststoff im Spritzverfahren hergestellten und auf dieser Rotorwelle 1 festsitzenden Sperrad 2 und aus einem mit diesem Sperrad 2 zusammenwirkenden Sperrorgan in Form eines Sperrhebels 4, der in einem auf dem Rahmen des Elektrizitätszählers befestigten Lagerbock 3 drehbar gelagert ist. Das Sperrad 2 weist auf seinen beiden Stirnseiten 5, 6 im Randbereich je einen Verzahnungskranz 7, 8 auf, dessen sägezahnförmigen Zähne 9 mit einander abgewandten Kopfkreisen gegeneinander um eine halbe Zahnteilung versetzt sind. Die Sperrflächen der Zähne 9 stehen senkrecht zu den Stirnflächen 5, 6 des Sperrades 2 und in radialer Richtung zu demselben.

Der Sperrhebel 4 ist mit zwei gegenüberliegenden dreieckigen Zähnen 10, 11 versehen, die in die Verzahnung der Verzahnungskränze 7, 8 in axialer Richtung der Rotorwelle 1 eingreifen. Der Abstand "a" der beiden Zähne 10, 11 des Sperrhebels 4 voneinander, d.h. der Abstand ihrer Kopfkreise, ist kleiner als der Abstand "b" der Kopfkreise der beiden Verzahnungskränze 7, 8 des Sperrades 2. Der Sperrhebel 4 ist in seinem Schwerpunkt P im Lagerbock 3 drehbar so gelagert, dass er in seinem Arbeitsbereich annähernd in axialer Richtung der Rotorwelle 1 ausgelenkt werden kann.

Dreht sich nun die Rotorwelle 1 des Elektrizitätszählers mit dem auf der Rotorwelle 1 befestigten Impulsgeber in Vorwärtsrichtung, so wird der Sperrhebel 4 abwechslungsweise nach oben und nach unten in axialer Richtung ausgelenkt, weil die Zähne 10, 11 an den Ablaufflächen der Zähne 9 der Verzahnungskränze 7, 8 entlanggleiten. Aendert der Elektrizitätszähler die Drehrichtung, so kommt zwangsweise der eine oder der andere Zahn 10, 11 des Sperrhebels 4 mit der Sperrfläche des am nächsten liegenden Zahnes 9 des Sperrades 2 in Eingriff, wodurch die Rückwärtsbewegung der Rotorwelle 1 und somit des Impulsgebers gestoppt wird. Auf diese Weise werden Fehlimpulse des Impulsgebers beim Zurückdrehen des Rotors des Elektrizitätszählers auf ein Minimum beschränkt oder sogar gänzlich verhindert.

Anstatt einer Versetzung der Zähne 9 des Sperrades 2 um eine halbe Teilung können auch die Zähne 10, 11 des Sperrhebels 4 um diese halbe Teilung gegeneinander versetzt sein.

Das beschriebene Ausführungsbeispiel weist ein Sperrad 2 auf, welches stirnseitig im Randbereich mit aussen liegenden Verzahnungskränzen 7, 8 versehen ist, was aus Fertigungsgründen vorteilhaft ist. Im Prinzip ist es auch möglich, das Sperrad 2 aus zwei gleichen Teilen herzustellen und diese Teile so zusammenzusetzen, dass deren mit den Verzahnungskränzen 7, 8, versehene Flächen gegeneinander liegen und einen Innenraum bilden, in welchem sich dann lediglich ein einziger dreieckiger Zahn des Sperrhebels 4 befindet. Wie im vorher beschriebenen Beispiel gleitet der Zahn des Sperrhebels 4 bei der Vorwärtsbewegung des Elektrizitätszählers an den Ablaufflächen der Zähne 9 entlang. Bei der Rückwärtsbewegung des Elektrizitätszählers kommt er aber mit der Sperrfläche des nächstliegenden Zahnes 9 in Eingriff und verhindert die Rückwärtsbewegung.

Die beschriebene erfindungsgemässe Rücklaufsperre beseitigt weitgehend die Nachteile, die den bekannten Ausführungen anhaften. Sie arbeitet verlässlich auch bei einer eventuellen Verschmutzung der Lagerstelle des Sperrhebels 4. Die Beeinflussung des Anlaufes des Elektrizitätszählers ist vernachlässigbar klein. Durch die im Rotor des Elektrizitätszählers vorhandenen vom ständig erregten Spannungssystem verursachten Rüttelkräfte wird der im Schwerpunkt P gelagerte Sperrhebel 4 vom Sperrrad 2 weggedrängt, so dass der laufende Rotor nur sehr geringfügig gebremst wird. Die Rüttelkräfte bewirken auch bei Stillstand des Rotors, dass immer ein Luftspalt zwischen dem Sperrhebel 4 und dem Sperrrad 2 entsteht. Wegen ihrer robusten Konstrukton und der äusserst geringen Reibung besitzt die beschriebene Rücklaufsperre eine lange Lebensdauer. Weil an die Fertigungstoleranzen und an die verwendeten Werkstoffe keine besonderen Ansprüche gestellt werden müssen, ist der Aufwand für die Herstellung gering.

**Patentansprüche**

1. Mehrere Sperrstellen aufweisende, gesteuerte Rücklaufsperre für Impulsgeber eines Meßgerätes, mit einem auf der Rotorwelle (1) dieses Gerätes festsitzenden kranzförmigen verzahnten Sperrad (2) und mit einem mit diesem Sperrad (2) zusammenwirkenden Sperrorgan (4), welches in der Vorwärtsdrehrichtung der Rotorwelle (1) an den Ablaufflächen der Verzahnung des Sperrades (2) entlanggleitet und welches das Rüchwärtsdrehen der Rotorwelle (1) durch Eingreifen an Sperrflächen der Verzahnung in axialer Richtung der Rotorwelle (1) verhindert, dadurch gekennzeichnet, daß die Verzahnung des Sperrades (2) aus mindestens zwei Verzahnungskränzen (7, 8) besteht, in welche das Sperrorgan (4) durch zwangsweise Auslenkung abwechselnd eingreift.

2. Rücklaufsperre nach Anspruch 1, dadurch gekennzeichnet dass die Verzahnungskränze (7, 8) im Randbereich auf beiden Stirnseiten des Sperrades (2) angeordnet sind und ihre Zähne (9) mit einander abgewandten Kopfkreisen gegeneinander um eine halbe Teilung versetzt sind.

3. Rücklaufsperre nach Anspruch 1 oder 2, dadurch gekennzeichnet, dass die Sperrflächen der Zähne (9) der Verzahnungskränze (7, 8) senkrecht zu den Stirnflächen (5, 6) und in radialer Richtung des Sperrades (2) angeordnet sind.

4. Rücklaufsperre nach Anspruch 1, dadurch gekennzeichnet, dass das Sperrorgang (4) zwei mit den Verzahnungskränzen (7, 8) zusammenwirkende Zähne (10, 11) aufweist und in seinem Schwerpunkt (P) drehbar in axialer Richtung der Rotorwelle (1) angeordnet ist.

5. Rücklaufsperre nach Anspruch 1, dadurch gekennzeichnet, dass das Sperrad (2) aus zwei Teilen besteht, deren mit Verzahnungskränzen (7, 8) versehene Flächen mit um eine halbe Teilung versetzten Zähnen (9) gegeneinander liegen und somit einen Zwischenraum bilden, in welchem ein einziger Zahn des Sperrorgans (4) angeordnet ist.

6. Rücklaufsperre nach Anspruch 4, dadurch gekennzeichnet, dass die Zähne (10, 11) des Sperrorgans (4) um eine halbe Teilung gegeneinander versetzt sind.

7. Rücklaufsperre nach einem der Ansprüche 1, 4, 5 oder 6, dadurch gekennzeichnet, dass das Sperrorgan (4) aus einem Hebel besteht.

**Claims**

1. A controlled reverse motion stopping device having a plurality of stop positions, for pulse generators of a measuring device, comprising a ring-shaped toothed stop wheel (2) which is fixed on the rotor shaft (1) of the measuring device, and a stop member (4) which co-operates with said stop wheel (2) and which in the direction of forward rotation of the rotor shaft slides along the back faces of the teeth of the stop wheel (2) and which prevents reverse rotary movement of the rotor shaft (1) by engaging against stop faces of the teeth in the axial direction of the rotor shaft (1), characterised in that the teeth of the stop wheel (2) comprise at least two toothed rings (7, 8) into which the stop member (4) engages alternately by virtue of positive deflection.

2. A reverse motion stopping device according to claim 1 characterised in that the toothed rings (7, 8) are arranged in the edge region on both faces of the stop wheel (2) and the teeth (9) thereof with their addendum circles facing away from each other are displaced relative to each other by half a pitch.

3. A reverse motion stopping device according to claim 1 or claim 2 characterised in that the stop faces of the teeth (9) of the toothed rings (7, 8) are arranged perpendicularly to the faces (5, 6) and in the radial direction of the stop wheel (2).

4. A reverse motion stopping device according to claim 1 characterised in that the stop member (4) has two teeth (10, 11) cooperating with the toothed rings (7, 8) and is arranged rotatably in the axial direction of the rotor shaft (11), at its centre of gravity (P).

5. A reverse motion stopping device according to claim 1 characterised in that the stop wheel (2) comprises two parts whose surfaces which are provided with toothed rings (7, 8) are disposed with their teeth (9) displaced by half a pitch towards each other and thus form an intermediate space in which a single tooth on the stop member (4) is arranged.

6. A reverse motion stopping device according to claim 4 characterised in that the teeth (10, 11) of the stop member (4) are displaced relative to each other by half a pitch.

7. A reverse motion stopping device according to one of claims 1, 4, 5 and 6 characterised in that the stop member (4) comprises a lever.

## Revendications

1. Dispositif anti-retour commandé, possédant plusieurs zones de retenue, pour générateur d'impulsions d'un appareil de mesure, comprenant une roue à rochet (2) dentée, en forme de couronne, calée sur l'arbre (1) du rotor de cet appareil et un organe de retenue (2) qui coopère avec ladite roue à rochet (2) et qui, dans le sens de rotation en marche avant de l'arbre (1) du rotor, glisse sur les surfaces de sortie de la denture de la roue à rochet (2) tandis qu'il s'oppose à la rotation en marche arrière de l'arbre (1) du rotor en s'engageant contre des surfaces de retenue de la denture dans la direction axiale de l'arbre (1) du rotor, caractérisé en ce que la denture de la roue à nrochet (2) est composée d'au moins deux couronnes dentées (7, 8) dans lesquelles l'organe de retenue (4) s'engage alternativement sous l'effet d'une déviation commandée positivement.

2. Dispositif anti-retour selon la revendication 1, caractérisé en ce que les couronnes dentées (7, 8) sont disposées dans la région du bord sur les deux faces frontales de la roue à rochet (2) et que leurs dents (9), qui présentent leurs cercles de têtes l'un à l'opposé de l'autre, sont décalées l'une par rapport à l'autre d'un demi-pas de denture.

3. Dispositif anti-retour selon la revendication 1 ou 2, caractérisé en ce que les surfaces de retenue des dents (9) des couronnes dentées (7, 8) sont disposées perpendiculairement aux surfaces frontales (5, 6), et dans des directions radiales de la roue à rochet (2).

4. Dispositif anti-retour selon la revendication 1, caractérisé en ce que l'organe de retenue (4) présente deux dents (10, 11) coopérant avec les couronnes dentées (7, 8) et est monté rotatif, au droit de son centre de gravité (P) pour tourner dans la direction axiale de l'arbre (1) du rotor.

5. Dispositif anti-retour selon la revendication 1, caractérisé en ce que la roue à rochet (2) est composée de deux pièces dont les surfaces munies de couronnes dentées (7, 8) et qui présentent des dents (9) décalées d'un demi-pas de denture, sont disposées face à face et forment ainsi un intervalle dans lequel est agencée une dent unique de l'organe de retenue (4).

6. Dispositif anti-retour selon la revendication 4, caractérisé en ce que les dents (10, 11) de l'organe de retenue (4) sont décalées l'une par rapport à l'autre d'un demi-pas de denture.

7. Dispositif anti-retour selon l'une des revendications 1, 4, 5 ou 6, caractérisé en ce que l'organe de retenue (4) est constitué par un levier.

0 131 679

Fig. 1

Fig. 2

Fig. 3

1